# EUROPEAN PATENT APPLICATION

(11) **EP 2 256 788 A1**
(43) Date of publication of application: **01.12.2010**
(21) Application number: 09716212.7
(22) Date of filing: 06.03.2009
(51) Int. Cl.: H01L 21/027, B29C 59/02, G11B 5/855

(54) **UV NANOIMPRINT METHOD, RESIN REPLICA MOLD AND METHOD FOR PRODUCING THE SAME, MAGNETIC RECORDING MEDIUM AND METHOD FOR PRODUCING THE SAME, AND MAGNETIC RECORDING/REPRODUCING APPARATUS**

(30) Priority: 07.03.2008 JP 2008057849; 14.03.2008 JP 2008066401
(71) Applicant: Showa Denko K.K., Tokyo 105-8518 (JP)
(72) Inventor: UCHIDA, Hiroshi, Tokyo 105-8518 (JP); FUKUSHIMA, Masato, Ichihara-shi Chiba 290-0067 (JP); SAKATA, Yuko, Tokyo 105-8518 (JP)
(74) Representative: Strehl Schübel-Hopf & Partner
(86) International application number: PCT/JP2009/054302
(87) International publication number: WO 2009/110596

(57) **Abstract**

A UV nanoimprint method comprising performing compression molding by pressing a mold having a pattern formed on the surface thereof against a work prepared by forming a thin film composed of an ultraviolet-curable resin on a substrate, and irradiating with ultraviolet light, either concurrently with the compression molding or after the compression molding, thereby transferring the pattern to the thin film, wherein the ultraviolet light is irradiated using an ultraviolet light irradiation apparatus equipped with temperature rise suppression means, and a light source that does not continuously emit heat rays together with ultraviolet light is used as a light source of the ultraviolet light irradiation apparatus.

## Description

### TECHNICAL FIELD

The present invention relates to a UV nanoimprint method that uses a resin mold and a work prepared by applying an ultraviolet-curable resin to a substrate mainly composed of a resin, wherein rise in the temperature of the mold is suppressed during irradiation of the ultraviolet light, and also relates to a resin replica mold and a magnetic recording medium produced using this method, and a magnetic recording/reproducing apparatus equipped with this magnetic recording medium.
Priority is claimed on Japanese Patent Application No. 2008-57849, filed March 7, 2008, and Japanese Patent Application No. 2008-66401, filed March 14, 2008, the contents of which are incorporated herein by reference.

### BACKGROUND ART

In recent years, with the increasing miniaturization of magnetic disk apparatus and semiconductor devices and the like, nanoimprint lithography has begun to attract considerable attention as a method capable of producing very fine patterns cheaply and with excellent throughput. For example, in magnetic disk recording/reproducing apparatus, increases in the track density cause mutual interference between the magnetically recorded information within adjacent tracks, and the resulting magnetized transition region in the boundary region between the tracks acts as a noise source, easily causing problems such as a deterioration in the high signal to noise ratio (SNR). In order to avoid these types of problems, tests are being conducted in which the track density is increased by forming a concave-convex pattern on the surface of the recording medium, thereby physically separating the recording tracks from one another. This technique is referred to as either the discrete track method or the patterned media method depending on the shape of the concave-convex pattern, and it has been suggested that nanoimprint lithography could be used within these methods as a technique for forming the concave-convex pattern with superior throughput (for example, see Patent Document 1).

Further, in the case of semiconductor devices, higher speed operations and reduced power consumption are being targeted by ever greater levels of miniaturization, and advanced techniques such as functional integration, which is referred to using the name "system LSI", are now also being demanded. Against this type of background, photolithography techniques, which represent the core technology within semiconductor device processes, tend to suffer from increasingly expensive equipment costs with increasing miniaturization. Accordingly, nanoimprint lithography is attracting much attention as a processing technique which is capable of achieving resolution in the order of 10 nm while requiring comparatively inexpensive equipment (for example, see Patent Document 2).

However, in these disk microfabrication processes, the precision of the processing is very important. However, because the mold on which the original pattern is formed and the work to which the pattern is to be transferred differ in flatness, the relative distance in the thickness direction between the work surface and the mold surface during the transfer process differs depending on the location, and this tends to cause a deterioration in the processing precision.
One method that has been disclosed to avoid this type of problem involves using a resin mold, thereby imparting the mold with sufficient flexibility to be able to conform to the shape of the work (see Patent Document 3).
On the other hand, it has also been disclosed that in those cases where a pattern is particularly fine, the use of an ultraviolet-curable resin for the layer on the side to which the pattern is to be transferred can be particularly effective (see Patent Document 4).
[Patent Document 1]
   Japanese Unexamined Patent Application, First Publication No. 2004-178793
[Patent Document 2]
   Published Japanese Translation No. 2004-504718 of the PCT International Publication
[Patent Document 3]
   Japanese Unexamined Patent Application, First Publication No. 2007-055235
[Patent Document 4]
   Japanese Unexamined Patent Application, First Publication No. 2000-194142

### DISCLOSURE OF THE INVENTION

### PROBLEMS TO BE SOLVED BY THE INVENTION

An example of the light source used during curing of the ultraviolet-curable resin is the widely used high-pressure mercury lamp. However, because this high-pressure mercury lamp emits heat rays as well as ultraviolet light, it is known that the temperature of the object being irradiated tends to increase. Accordingly, if this type of light source is used in a case where a resin is used as the mold or the work substrate, then because the volumetric change of resins under heat tends to be comparatively large, the mold or the work substrate undergo deformation, making it impossible to imprint a pattern that is true to the original design on the work.

The present invention takes the above circumstances into consideration, and has an object of providing a UV nanoimprint method which, in those cases where either a resin mold is used or UV nanoimprint lithography is performed on a thin film composed of an ultraviolet-curable resin formed on a resin substrate, suppresses rise in the temperature of the mold and the work, thereby enabling a pattern that is true to the original design to be transferred to the work.
In this description, the term "mold" describes an object with a concave-convex pattern formed thereon such as a mother stamper.
Further, the term "work" describes the target object to which this concave-convex pattern is to be transferred, and in this application, a substrate with a thin film of a curable resin formed thereon is exemplified as a work.

Further, another object of the present invention is to provide a method for producing a resin replica mold using the above UV nanoimprint method, and a resin replica mold produced using such a production method.
Moreover, yet another object of the present invention is to provide a method for producing a magnetic recording medium using the above UV nanoimprint method and the above resin replica mold, a magnetic recording medium produced using such a production method, and a magnetic recording/reproducing apparatus equipped with this magnetic recording medium.

### MEANS TO SOLVE THE PROBLEMS

In order to achieve the above objects, the present invention adopts the aspects described below.
[1] A UV nanoimprint method comprising performing compression molding by pressing a mold having a pattern formed on the surface thereof against a work prepared by forming a thin film composed of an ultraviolet-curable resin on a substrate, and irradiating with ultraviolet light, either concurrently with the compression molding or after the compression molding, thereby transferring the pattern to the thin film, wherein the ultraviolet light is irradiated using an ultraviolet light irradiation apparatus equipped with temperature rise suppression means that suppresses rise in a temperature of the work and the mold, and a light source that does not continuously emit heat rays together with ultraviolet light is used as a light source of the ultraviolet light irradiation apparatus.
[2] The UV nanoimprint method according to [1] above, wherein the temperature rise suppression means comprises using a light emitting diode-based light source as a light source of the ultraviolet light irradiation apparatus.
[3] The UV nanoimprint method according to [1] above, wherein the temperature rise suppression means comprises using a continuous pulsed emission-type light source as a light source of the ultraviolet light irradiation apparatus.
[4] The UV nanoimprint method according to [2] above, wherein the light emitting diode-based light source emits ultraviolet light with a wavelength of 360 to 370 nm.
[5] The UV nanoimprint method according to [3] above, wherein the continuous pulsed emission-type light source is a quartz xenon lamp.
[6] The UV nanoimprint method according to any one of [1] to [5] above, wherein the ultraviolet light is irradiated with a heat ray cut filter provided between the light source and the work.
[7] The UV nanoimprint method according to any one of [1] to [6] above, wherein the ultraviolet light irradiation apparatus comprises a stage on which the work is mounted, and the stage is subjected to cooling while the ultraviolet light is irradiated.

[8] A method for producing a resin replica mold, the method comprising using a thin film composed of an ultraviolet-curable resin formed on top of a resin film, and using the UV nanoimprint method according to any one of [1] to [7] above to transfer a mother stamper pattern to the thin film.
[9] The method for producing a resin replica mold according to [8] above, wherein the ultraviolet-curable resin is a solventless liquid.
[10] A resin replica mold produced using the method according to [8] or [9] above.

[11] A method for producing a magnetic recording medium, the method comprising forming a thin film composed of an ultraviolet-curable resin on a magnetic recording medium comprising a magnetic layer formed on the surface of a substrate, forming a pattern on the thin film using the UV nanoimprint method according to any one of [1] to [7] above, and processing the magnetic layer using the pattern.
[12] The method for producing a magnetic recording medium according to [11] above, wherein the resin replica mold according to [10] above is used as the mold.
[13] A magnetic recording medium produced using the method for producing a magnetic recording medium according to [11] or [12] above.
[14] A magnetic recording/reproducing apparatus equipped with the magnetic recording medium according to [13] above.

### EFFECT OF THE INVENTION

According to the UV nanoimprint method of the present invention, an ultraviolet light irradiation apparatus is used that enables suppression of rise in the temperature of the work and the mold caused by heat rays emitted from the ultraviolet light source. Consequently, when UV nanoimprinting is conducted using a resin mold, or using a work prepared by applying an ultraviolet-curable resin to a resin substrate, rise in the temperature of the work and the mold can be suppressed, enabling pattern formation by imprinting to be conducted with superior precision.
Further, according to the UV nanoimprint method of the present invention, a light emitting diode-based light source or a continuous pulsed emission-type light source is used as the temperature rise suppression means within the ultraviolet light irradiation apparatus. In the case of a light emitting diode-based light source, because heat rays are not emitted together with the ultraviolet light, rise in the temperature of the work and the mold can be effectively suppressed. Further, in the case of a continuous pulsed emission-type light source, because the irradiation of the heat rays occurs only intermittently, rise in the temperature of the work and the mold can be effectively suppressed.
Moreover, according to the UV nanoimprint method of the present invention, a heat ray cut filter may be provided between the light source and the work, and therefore irradiation of heat rays onto the work and the mold can be even better suppressed. In addition, the stage on which the work is mounted may be subjected to cooling while the ultraviolet light is irradiated, and therefore rise in the temperature of the work can be even better suppressed. As a result, pattern formation by imprinting can be conducted with superior precision.

According to the method for producing a resin replica mold of the present invention, because the UV nanoimprint method described above is used, a very fine pattern can be formed with superior precision.
According to the method for producing a magnetic recording medium of the present invention, a pattern formed using the above UV nanoimprint method is used as a mask for processing a magnetic film layer, and therefore a fine pattern can be formed with superior precision. Further, because a resin replica mold produced using the above method for producing a resin replica mold can be used, UV nanoimprinting of a very fine pattern can be conducted with superior precision even if the work substrate includes some deformation. As a result, a magnetic recording medium with a higher level of recording density than conventional media can be produced relatively inexpensively.

Moreover, the present invention is also able to provide a method for producing a magnetic recording medium that uses the UV nanoimprint method and the resin replica mold described above, a magnetic recording medium produced using such a production method, and a magnetic recording/reproducing apparatus equipped with such a magnetic recording medium.

### BRIEF DESCRIPTION OF THE DRAWINGS

FIG. 1 is a process cross-sectional view illustrating a UV nanoimprint method that represents one embodiment of the present invention.
FIG. 2 is a process cross-sectional view illustrating a UV nanoimprint method that represents one embodiment of the present invention.
FIG. 3 is a process cross-sectional view illustrating a UV nanoimprint method that represents one embodiment of the present invention.
FIG. 4 is a process cross-sectional view illustrating a UV nanoimprint method that represents one embodiment of the present invention.
FIG. 5 is a process cross-sectional view illustrating a UV nanoimprint method that represents one embodiment of the present invention.
FIG. 6 is a process cross-sectional view illustrating a UV nanoimprint method that represents one embodiment of the present invention.
FIG. 7 is a process cross-sectional view illustrating a UV nanoimprint method that represents one embodiment of the present invention.
FIG. 8 is a process cross-sectional view illustrating a UV nanoimprint method that represents one embodiment of the present invention.
FIG. 9 is a process cross-sectional view illustrating a UV nanoimprint method that represents one embodiment of the present invention.
FIG. 10 is a process cross-sectional view illustrating a UV nanoimprint method that represents one embodiment of the present invention.
FIG. 11 is a process cross-sectional view illustrating a UV nanoimprint method that represents one embodiment of the present invention.
FIG. 12 is a process cross-sectional view illustrating a UV nanoimprint method that represents one embodiment of the present invention.
FIG. 13 is a process cross-sectional view illustrating a UV nanoimprint method that represents one embodiment of the present invention.
FIG. 14 is a process cross-sectional view illustrating a UV nanoimprint method that represents one embodiment of the present invention.
FIG. 15 is a process cross-sectional view illustrating a method for producing a magnetic recording medium that represents one embodiment of the present invention.
FIG. 16 is a process cross-sectional view illustrating a method for producing a magnetic recording medium that represents one embodiment of the present invention.
FIG. 17 is a process cross-sectional view illustrating a method for producing a magnetic recording medium that represents one embodiment of the present invention.
FIG. 18 is a perspective view for describing an example of the present invention.
FIG. 19 is a perspective view for describing an example of the present invention.
FIG. 20 is a perspective view for describing an example of the present invention.
FIG. 21 is a perspective view for describing an example of the present invention.
FIG. 22 is a diagram illustrating the spectrum of a light source used in example 3 of the present invention.

### DESCRIPTION OF THE REFERENCE SYMBOLS

1: Stage
2: Work
2a: Substrate
2b: Thin film
3: Mold
3a: Pattern
4: Ultraviolet light source (source of ultraviolet light)
5: Guide
6: Chuck channel
7: Flow passage
8: Sensor of ultraviolet intensity meter
9: Diffusion plate
10: Light guide
11: Weight
12: Guide rail
13: Press plate
14: Heat ray cut filter
15: Holder
16: Water tank
17: Outlet
18: Non-magnetic substrate
19: Magnetic layer
20: Protective layer
21: Magnetic recording medium
22: Thin film composed of ultraviolet-curable resin
23: Mold
24: Non-magnetic material
25: Protective layer
26: Flow passage
27: Stainless steel plate
28: Work
29: Mother stamper
30: Pattern region
31: Pattern

### BEST MODE FOR CARRYING OUT THE INVENTION

Preferred embodiments of the present invention are described below in detail with reference to the drawings. It should be noted that the scope of the present invention is in no way limited by the embodiments described below. Moreover, the drawings below are provided to explain the constitutions of the embodiments of the present invention, and the size, thickness and dimensions and the like of each of the elements illustrated in the drawings may differ from the dimensional relationships observed within the actual UV nanoimprint method and the like.

### <UV nanoimprint method>

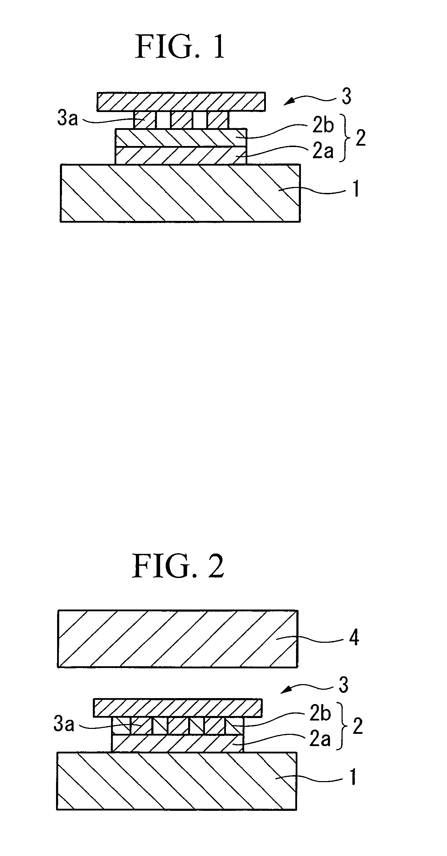

FIG. 1 to FIG. 14 are process cross-sectional views illustrating a UV nanoimprint method that represents one embodiment of the present invention. The UV nanoimprint method of this embodiment of the present invention includes performing compression molding by pressing a resin mold having a pattern formed on the surface thereof against a work prepared by forming a thin film composed of an ultraviolet-curable resin on a resin substrate, and irradiating with ultraviolet light, either concurrently with the compression molding or after the compression molding, thereby transferring the pattern to the thin film, wherein the ultraviolet light irradiation is performed using an ultraviolet light irradiation apparatus equipped with a temperature rise suppression means that suppresses temperature rise during the ultraviolet light irradiation. The method may be conducted, for example, in the manner described below.

In the UV nanoimprint method of this embodiment, first, as illustrated in FIG. 1, a work 2 prepared by applying an ultraviolet-curable resin to the top surface of a substrate 2a to form a thin film 2b is mounted on a stage 1. Next, a mold 3 which has a pattern 3a formed on the surface thereof and transmits ultraviolet light is mounted on top of the work 2 with the patterned surface facing downward. Subsequently, as illustrated in FIG. 2, pressure is applied from the top of the mold 3, thereby pressing the work 2 and the mold 3 into close contact, and ultraviolet light is then irradiated using an ultraviolet light source (a source of ultraviolet light) 4. As a result, the pattern 3a of the mold 3 can be transferred to the thin film composed of the ultraviolet-curable resin. In the UV nanoimprint method according to this embodiment, the ultraviolet light irradiation is performed using an ultraviolet light irradiation apparatus equipped with a temperature rise suppression means, and the ultraviolet light irradiation apparatus is composed basically of the stage 1 and the ultraviolet light source 4.

### (Stage)

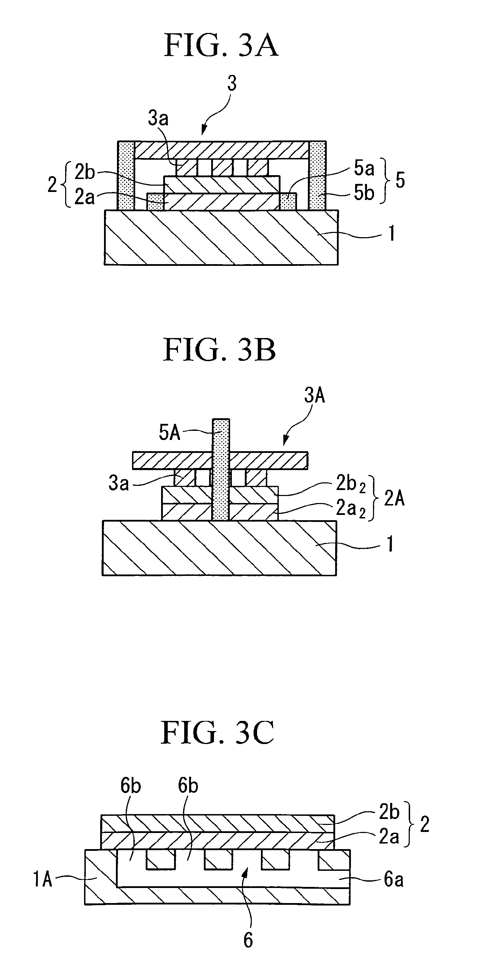

There are no particular limitations on the material or the shape of the stage 1, provided it is capable of holding the work 2 and the mold 3 in a stable manner. Further, the stage 1 may also be provided with a holding device for the work 2 and the mold 3. There are no particular limitations on this holding device, and any device capable of appropriately positioning the work 2 and the mold 3 may be used. FIG. 3 is a cross-sectional view illustrating the stage 1 with the work 2 and the mold 3 provided thereon. As illustrated in FIG. 3A, the holding device may be a guide 5 provided on the stage 1. This guide 5 is composed of a frame-like inner guide 5a that positions the outer periphery of the work 2, and a frame-like outer guide 5b that positions the outer periphery of the mold 3. This guide 5 fixes the outside edges of the work 2 and the mold 3. Alternatively, as illustrated in FIG. 3B, the holding device may be a rod-shape guide 5A arranged vertically within the center of the stage 1. By passing this guide 5A through holes provided within the work 2A and the mold 3A, the positions of the work 2A and the mold 3A can be fixed. Alternatively, as illustrated in FIG. 3C, the holding device may be a chuck channel 6 provided within a stage 1A. This chuck channel 6 is composed of an evacuation passage 6a, and a plurality of suction holes 6b that are connected to the evacuation passage 6a and penetrate through to the top surface of the stage 1A. By applying suction to the evacuation passage 6a, the work 2 is suctioned onto the top of the stage 1A via the suction holes 6b, enabling the work 2 to be vacuum chucked to the top of the stage 1A. This enables the work 2 to be positioned relative to the stage 1A.

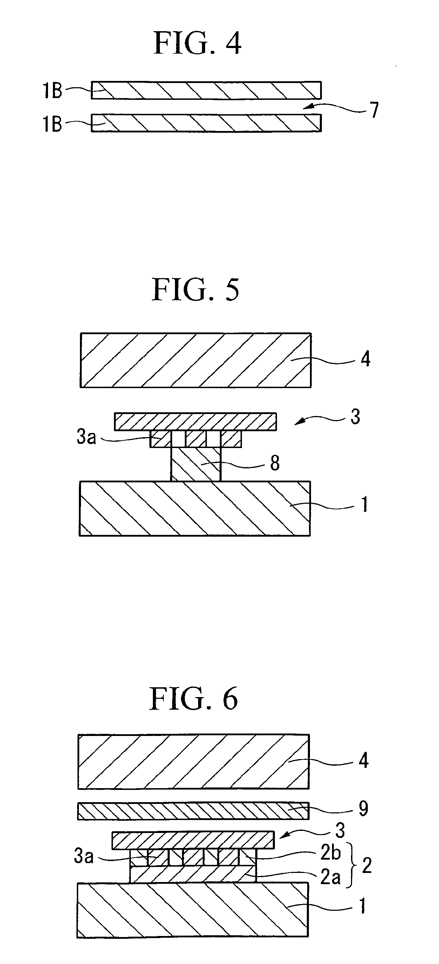

Furthermore, as illustrated in FIG. 4, a flow passage 7 through which a fluid can be passed may be provided within the interior of a stage 1B. By passing cooling water or a coolant gas through this flow passage 7, the ultraviolet light irradiation can be performed while the stage 1B is cooled, thereby enabling prevention of rise in the temperature of the work 2 and the mold 3 during the ultraviolet light irradiation.

### (Mold)

There are no particular limitations on the material of the mold 3 used when performing the UV nanoimprint method of the present embodiment in the manner illustrated in FIG. 2, although a material that transmits at least 20% of the ultraviolet light of wavelength 220 to 400 nm emitted from the ultraviolet light source 4 is preferred. If the ultraviolet light transmittance of the mold 3 is too low, then curing the ultraviolet-curable resin may take too long, meaning the UV nanoimprinting cannot be performed efficiently.

Examples of materials for the mold 3 that are capable of transmitting at least 20% of the ultraviolet light from the ultraviolet light source 4 include quartz glass, glass, cycloolefin polymers (such as the product ZEONOR manufactured by Zeon Corporation), cycloolefin copolymers (such as the product APEL manufactured by Mitsui Chemicals, Inc., and the product TOPAS manufactured by Polyplastics Co., Ltd.), polyethylene terephthalate, poly(4-methyl-pentene-1), and polycarbonate. In addition, various ultraviolet-curable resins may also be used, provided the thickness is not more than 1 mm. These materials may be used individually, in mixtures, or within laminated products containing two or more layers, although in those cases where the substrate of the work 2 is formed of a material with low flexibility, the material for the mold 3 is preferably a resin material such as a cycloolefin polymer, cycloolefin copolymer, polyethylene terephthalate, poly(4-methyl-pentene-1), polycarbonate, or any of various ultraviolet-curable resins.

Further, the thickness of the mold 3 is preferably within a range from not less than 20 µm to not more than 10 cm. Ensuring that the thickness of the mold 3 satisfies this range facilitates handling, and is therefore preferred. Moreover, the size of the mold 3 is preferably larger than the size of the work 2. A mold 3 that is larger than the work 2 facilitates operations such as mold release, and is therefore preferred.

### (Resin replica mold)

All manner of so-called resin replica molds may be used, including resin molds prepared by using a film as the resin substrate, subsequently applying an ultraviolet-curable composition to the top of this resin film, and then transferring the pattern from a mother stamper to this film by UV nanoimprinting, resin molds prepared by transferring the pattern from a mother stamper to a thermoplastic resin by thermal nanoimprinting, and resin molds produced by injection compression molding. However, in those cases where mold productivity and pattern transferability are particularly important, the use of a resin replica mold prepared by applying an ultraviolet-curable composition to the top of a resin film, and then transferring the pattern from a mother stamper to this film by UV nanoimprinting is particularly desirable.

The resin film described above is preferably a film having a thickness of not less than 30 µm and not more than 1 mm, composed of a cycloolefin polymer (such as the product ZEONOR manufactured by Zeon Corporation), cycloolefin copolymer (such as the product APEL manufactured by Mitsui Chemicals, Inc., or the product TOPAS manufactured by Polyplastics Co., Ltd.), polyethylene terephthalate, poly(4-methylpentene-1), or polycarbonate. This enables the handling properties and the ultraviolet light transmittance of the produced mold 3 to be adjusted to appropriate levels.

### (Ultraviolet-curable resin)

There are no particular limitations on the types of ultraviolet-curable resin that can be used in the present embodiment, and any compound which when applied as a thin film and then irradiated with ultraviolet light cures to form a resin film, or any composition that contains such a compound, may be used as the material for forming the ultraviolet-curable resin film. Specific examples of the ultraviolet-curable resin include resins (oligomers) having curable groups such as (meth)acryloyl groups, vinyl ether groups, N-vinylamide groups, vinyl ester groups, styryl groups (aromatic vinyl groups), oxetanyl groups, glycidyl groups and cyclohexene oxide groups, and compositions containing a monomer and/or resin (oligomer) containing these curable groups. The use of compositions containing a monomer and/or resin (oligomer) having curable groups that exhibit rapid curability, such as (meth)acryloyl groups, oxetanyl groups or cyclohexene oxide groups, is particularly desirable.

Specific examples of the monomers or resins (oligomers) having a (meth)acryloyl group that may be used in the present embodiment include monomers, including aliphatic mono(meth)acrylates such as methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, hexyl (meth)acrylate, octyl (meth)acrylate, 2-ethylhexyl (meth)acrylate, decyl (meth)acrylate, isobornyl (meth)acrylate, cyclohexyl (meth)acrylate, 2-hydroxyethyl (meth)acrylate, 2-hydroxypropyl (meth)acrylate, 3-hydroxypropyl (meth)acrylate and 2-hydroxybutyl (meth)acrylate; aromatic mono(meth)acrylates such as phenyl (meth)acrylate, benzyl (meth)acrylate and 2-hydroxyphenylethyl (meth)acrylate; (meth)acrylamides such as N,N-dimethyl (meth)acrylamide, N,N-diethyl (meth)acrylamide and N-acryloylmorpholine; aliphatic polyfunctional (meth)acrylates such as ethylene glycol di(meth)acrylate, propylene glycol di(meth)acrylate, 1,4-butanediol di(meth)acrylate, diethylene glycol di(meth)acrylate, triethylene glycol di(meth)acrylate, trimethylolpropane di(meth)acrylate, trimethylolpropane tri(meth)acrylate and pentaerythritol penta(meth)acrylate; aromatic polyfunctional acrylates such as ethylene oxide-modified bisphenol A (meth)acrylate and propylene oxide-modified bisphenol A (meth)acrylate; and fluorine-containing (meth)acrylates such as 2-trifluoromethylpropenoic acid trifluoroethyl ester, 2-trifluoromethylpropenoic acid t-butyl ester, 2,2,2-trifluoroethyl (meth)acrylate, 2,2,3,3-tetrafluoropropyl (meth)acrylate, 1H,1H,5H-octafluoropentyl (meth)acrylate and perfluorooctylethyl (meth)acrylate; as well as so-called epoxy (meth)acrylates produced by the addition of (meth)acrylic acid to an epoxy resin, such as bisphenol A epoxy resins, hydrogenated bisphenol A epoxy resins, brominated bisphenol A epoxy resins, bisphenol F epoxy resins, novolak epoxy resins, phenol novolak epoxy resins, cresol novolak epoxy resins, alicyclic epoxy resins, N-glycidyl epoxy resins, bisphenol A novolak epoxy resins, chelated epoxy resins, glyoxal epoxy resins, amino group-containing epoxy resins, rubber-modified epoxy resins, dicyclopentadiene phenolic epoxy resins, silicone-modified epoxy resins and ε-caprolactone-modified epoxy resins; and various urethane (meth)acrylates.

Examples of the monomers having a vinyl ether group include aliphatic monovinyl ethers such as 2-ethylhexyl vinyl ether, octadecyl vinyl ether, 4-hydroxybutyl vinyl ether, diethylene glycol monovinyl ether, triethylene glycol monovinyl ether, 9-hydroxynonyl vinyl ether, methoxyethyl vinyl ether and ethoxyethyl vinyl ether; alicyclic monovinyl ethers such as cyclohexyl vinyl ether, 4-hydroxycyclohexyl vinyl ether, cyclohexanedimethanol monovinyl ether and tricyclodecanyl vinyl ether; aliphatic divinyl ethers such as 1,4-butanediol divinyl ether, nonanediol divinyl ether and triethylene glycol divinyl ether; alicyclic divinyl ethers such as cyclohexanediol divinyl ether, cyclohexanedimethanol divinyl ether, tricyclodecanedimethanol divinyl ether and pentacyclopentadecanedimethanol divinyl ether; and polyfunctional vinyl ethers such as trimethylolpropane trivinyl ether and pentaerythritol tetravinyl ether.
Examples of the monomers having an N-vinylamide group include N-vinylformamide and N-vinylpyrrolidone.
Examples of the resins having vinyl ester groups include the RIPOXY series of products manufactured by Showa Highpolymer Co., Ltd., the DICLITE series of products manufactured by DIC Corporation, and the NEOPOL series of products manufactured by Japan U-PICA Co., Ltd.
Examples of the monomers having a styryl group include styrene, styrene derivatives such as 2,4-dimethyl-α-methylstyrene, o-methylstyrene, m-methylstyrene and p-methylstyrene, as well as divinylbenzene and divinylbiphenyl.
Examples of the monomers having a glycidyl group include glycidol, allyl glycidyl ether, glycidyl (meth)acrylate, 2-ethylhexyl glycidyl ether, phenyl glycidyl ether, ethylene glycol diglycidyl ether, propylene glycol diglycidyl ether, 1,6-hexanediol diglycidyl ether, diethylene glycol diglycidyl ether, hydrogenated bisphenol A diglycidyl ether, diglycidyl terephthalate, diglycidyl ortho-phthalate, N-glycidylphthalimide, glycerol polyglycidyl ether and trimethylolpropane polyglycidyl ether. Further, examples of the resins containing glycidyl groups include polymers of allyl glycidyl ether, polymers of glycidyl (meth)acrylate, bisphenol A epoxy resins, hydrogenated bisphenol A epoxy resins, bisphenol F epoxy resins, novolak epoxy resins and N-glycidyl epoxy resins.

Examples of the monomers having a cyclohexene oxide group include cyclohexene oxide, 1,2-epoxy-4-vinylcyclohexane, allyl 3,4-epoxycyclohexanecarboxylate, 3,4-epoxycyclohexylmethyl (meth)acrylate, 1,2:8,9-diepoxylimonene, and the product CELLOXIDE 2021P manufactured by Daicel Chemical Industries, Ltd. Further, examples of the resins having cyclohexene oxide groups include polymers of allyl 3,4-epoxycyclohexanecarboxylate, polymers of 3,4-epoxycyclohexylmethyl (meth)acrylate, the product EPOLEAD GT401 manufactured by Daicel Chemical Industries, Ltd., the product EHPE 3150 manufactured by Daicel Chemical Industries, Ltd., and the product EHPE 3150CE manufactured by Daicel Chemical Industries, Ltd.
Furthermore, examples of the monomers or resins having an oxetanyl group include the ARON OXETANE series of products manufactured by Toagosei Co., Ltd., and the ETERNACOLL OXETANE series of products manufactured by Ube Industries, Ltd.
Further, commercially available nanoimprinting UV-curable resins may also be used, including the product PAK-01 (manufactured by Toyo Gosei Co., Ltd.) and the product NIF-A-1 (manufactured by Asahi Glass Co., Ltd.).

These compounds (monomers or resins (oligomers)) for the ultraviolet-curable resin may be used individually, or in combinations containing two or more different compounds, although in those cases where following application of the ultraviolet-curable composition to a film, the resulting structure is to be stored for a long period of time, the use of a composition containing at least 50% by mass of either a solid or a resin having a viscosity at room temperature of 100,000 mPa·s or greater is preferred. On the other hand, in those cases where the precision of the pattern formed in the resin replica mold is particularly important, the use of a liquid resin having a viscosity at room temperature of not more than 10,000 mPa·s is preferred. The viscosity of the liquid resin can be measured, for example, using a rotational viscometer. When the ultraviolet-curable composition is applied to the film, if required the composition may also include a photopolymerization initiator and/or a sensitizer, as well as a surface modifier, viscosity modifier or solvent or the like.

There are no particular limitations on the method used for applying these ultraviolet-curable compositions to a film, and typical methods such as spin coating, dip coating, bar coating, screen printing and gravure printing may be used in accordance with the viscosity and thickness of the resin that is to be applied to. The ultraviolet-curable resin is preferably applied so that the thickness of the applied layer is not more than 100 µm. If the applied ultraviolet-curable resin layer is too thick, then when UV nanoimprinting is performed using the produced mold, the light transmittance of the ultraviolet light tends to decrease, and the UV nanoimprinting tends to take a long time.
When the above-mentioned ultraviolet-curable composition is applied to a resin replica mold, the ultraviolet-curable composition is preferably a solventless liquid. This improves the handling during application of the ultraviolet-curable composition to the film, and enables the UV nanoimprinting time to be shortened, thereby favorably improving the productivity.

There are no particular limitations on the conditions and method used when transferring the pattern from the mother stamper to the film of the applied ultraviolet-curable composition (namely, the resin replica mold production conditions and production method), and these may be selected appropriately in accordance with the properties of the applied ultraviolet-curable composition to the film. However, needless to say, in the present embodiment it is preferable that the pattern transfer is conducted in such a manner that the temperature of the film does not rise, by using a light emitting diode-based or continuous pulsed emission-type light source 4 described below, or also employing any of the various other devices disclosed in the description of the present invention as required.
In this description, the term "ultraviolet-curable resin" describes a compound (a monomer or resin (oligomer)) which when applied as a film and then irradiated with ultraviolet light cures to form a resin film, or a composition that contains such a compound.

### (Ultraviolet light source)

Conventionally, when the work 2 and the mold 3 are irradiated with ultraviolet light using an ultraviolet light irradiation apparatus not equipped with a temperature rise suppression means, heat rays (infrared radiation) are also irradiated onto the work 2 and the mold 3 together with the ultraviolet light, and these heat rays can cause thermal damage.
The UV nanoimprint method according to a first embodiment of the present invention is a method that uses an ultraviolet light irradiation apparatus equipped with a temperature rise suppression means to irradiate ultraviolet light having an emission wavelength of not less than 320 nm and not more than 400 nm, and preferably not less than 360 nm and not more than 370 nm. As a result, irradiation of heat rays onto the work 2 and the mold 3 can be suppressed, enabling rise in the temperature of the work 2 and the mold 3 to be suppressed.
Further, the UV nanoimprint method according to a second embodiment of the present invention preferably uses ultraviolet light having an emission wavelength of not less than 220 nm and not more than 400 nm, although even if this ultraviolet light is mixed with light of other wavelengths, because a continuous pulsed emission-type light source is used, heat rays are only irradiated intermittently, enabling rise in the temperature of the work 2 and the mold 3 to be suppressed.
The "heat rays" mentioned above are composed of near infrared radiation having a wavelength within a range from 750 to 4,000 nm, and far infrared radiation having a wavelength of 4,000 to 100,000 nm, although suppressing the irradiation of heat rays having a wavelength within a range from 800 to 2,000 nm is particularly preferred in terms of suppressing temperature rise.
Furthermore, as the continuous pulsed emission-type light source, a quartz xenon type light source is preferred in terms of factors such as the curing rate of the ultraviolet-curable resin and the light emission efficiency.
Specific examples of such light sources include the product Aicure ANUP-8 manufactured by Matsushita Electric Works Co., Ltd., and the product RC-742 manufactured by Xenon Corporation, U.S.A. The shape of the lamp may be selected appropriately from among rod-shaped, ring-shaped, spiral-shaped, helix-shaped and lattice-shaped lamps in accordance with the work. The lamp output may be set within a range from 300 to 20,000 W/cm² in accordance with the reactivity of the curable resin. The irradiation time per pulse is preferably within a range from 1/10,000,000 to 1/100 second, and more preferably from 1/1,000,000 to 1/50,000 second. If the irradiation time per pulse is too long, then the rise in the temperature of the work caused by heat rays becomes undesirably large, whereas if the irradiation time per pulse is too short, then it may approach the limits of the apparatus, resulting in problems such as a reduced apparatus lifespan. The pulse interval is preferably within a range from 1 to 1,000 Hz, and more preferably from 2 to 100 Hz. If the pulse interval is too short, then the work temperature tends to rise undesirably, whereas if the interval is widened too far, then the curing time becomes overly long, which is also undesirable.

As the temperature rise suppression means, a light emitting diode-based light source or continuous pulsed emission-type light source is used as the ultraviolet light source 4 within the ultraviolet light irradiation apparatus. The former does not emit heat rays concurrently with the ultraviolet light, and the latter only emits heat rays intermittently, and therefore rise in the temperature of the work 2 and the mold 3 is suppressed during the ultraviolet light irradiation.
In those cases where a light emitting diode-based light source is used as the ultraviolet light source 4, the emission wavelength is preferably not less than 320 nm and not more than 400 nm, and is more preferably not less than 360 nm and not more than 370 nm. A light source having an emission wavelength within this range is preferred in terms of factors such as availability and the curing rate of the ultraviolet-curable resin.
A feature of light emitting diodes (LED) is their extremely narrow emission wavelength band, and whereas the main wavelength component of the light emitting diode-based light source used for the ultraviolet light irradiation is 400 nm or less, the wavelength of so-called "heat rays" is within the near infrared spectrum from 700 or 800 nm through to several thousand nm. As a result, the light emitting diode-based light source does not emit heat rays concurrently with the ultraviolet light.

There are no particular limitations on the actual configuration of the ultraviolet light source 4, and commercially available spot light sources or lamp type light sources may be used. Further, in those cases where a light emitting diode-based light source is used, a special light source may be fabricated in which the light emitting diode elements are arranged in accordance with the shape of the work 2 and the like. Moreover, a single light source, a plurality of light sources, or a combination of different light sources may be used, although the light source(s) must be positioned so that the ultraviolet light intensity is substantially uniform across the work 2, and in those cases where a light emitting diode-based light source is used, must be positioned so that heat emitted from the light emitting diode elements and the peripheral wiring is dissipated enough to prevent excessive increases in the temperature of the light source. If the light intensity reaching the work 2 is uneven, then overexposed portions and underexposed portions will occur within the ultraviolet-curable resin film, which may result in problems such as peeling faults and therefore it is not preferable. Further, if the temperature of the ultraviolet light source 4 increases excessively, then the lifetime of the light source tends to shorten markedly, which is undesirable from an economic perspective.

As illustrated in FIG. 5, the ultraviolet light intensity reaching the work 2 can be measured by positioning a sensor of ultraviolet intensity meter 8 instead of the work 2 in the position in which the work 2 is located during UV nanoimprinting (during ultraviolet light irradiation), and then activating the ultraviolet light source 4. Furthermore, in those cases where simply adjusting the positioning of the light source is unable to achieve sufficient uniformity of the light intensity, a diffusion plate 9 may be interposed between the mold 3 and the ultraviolet light source 4, as illustrated in FIG. 6.
There are no particular limitations on the distance between the ultraviolet light source 4 and the work 2, and the distance between the ultraviolet light source 4 and the mold 3, although in both cases, a distance of at least 1 mm is preferred in terms of ensuring that heat from the light emitting diode elements and the peripheral wiring is not transmitted to the work 2 and the mold 3. If this heat is transmitted to the work 2 and the mold 3, then the pattern formed on the mold 3 may deform, making a high-precision transfer of the pattern impossible.

### (Modified example of ultraviolet light irradiation method)

The description above focuses on an ultraviolet light irradiation method in which, as illustrated in FIG. 1 and FIG. 2, the work 2 and the mold 3 are mounted on top of the stage 1, pressure is applied to the mold 3 to bring the mold 3 into close contact with the work 2, and ultraviolet light is then irradiated from the ultraviolet light source 4, but the UV nanoimprint method of the present embodiment is not limited to this particular irradiation method.

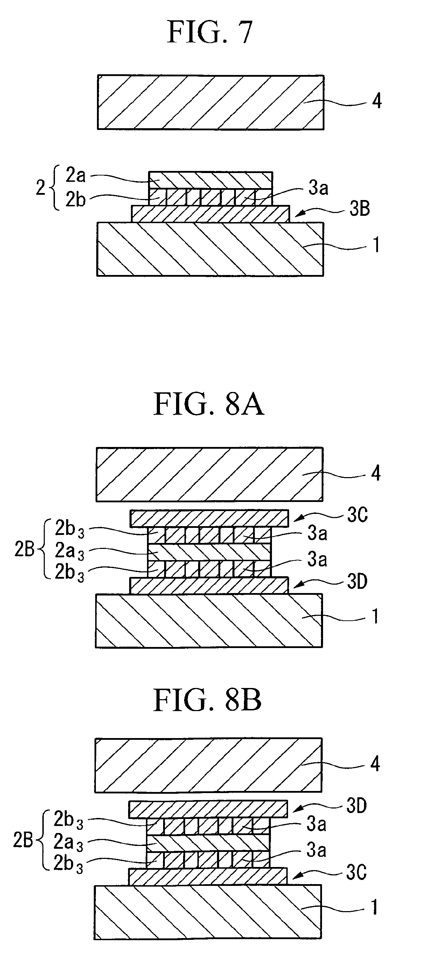

For example, as illustrated in FIG. 7, a method may be employed in which a mold 3B is mounted on the stage 1, the work 2 is positioned on top of the mold 3B, and ultraviolet light is then irradiated from an ultraviolet light source 4 positioned above the work 2. In this case, the work 2 must be capable of transmitting the ultraviolet light, but the mold 3B may or may not transmit ultraviolet light. Further, as illustrated in FIG. 8A and FIG. 8B, a work 2B prepared by applying an ultraviolet-curable resin to both surfaces of a substrate 2a₃ to form thin films 2b₃ may be sandwiched between molds 3C and 3D that transmit ultraviolet light and subsequently irradiated with ultraviolet light from the ultraviolet light source 4.

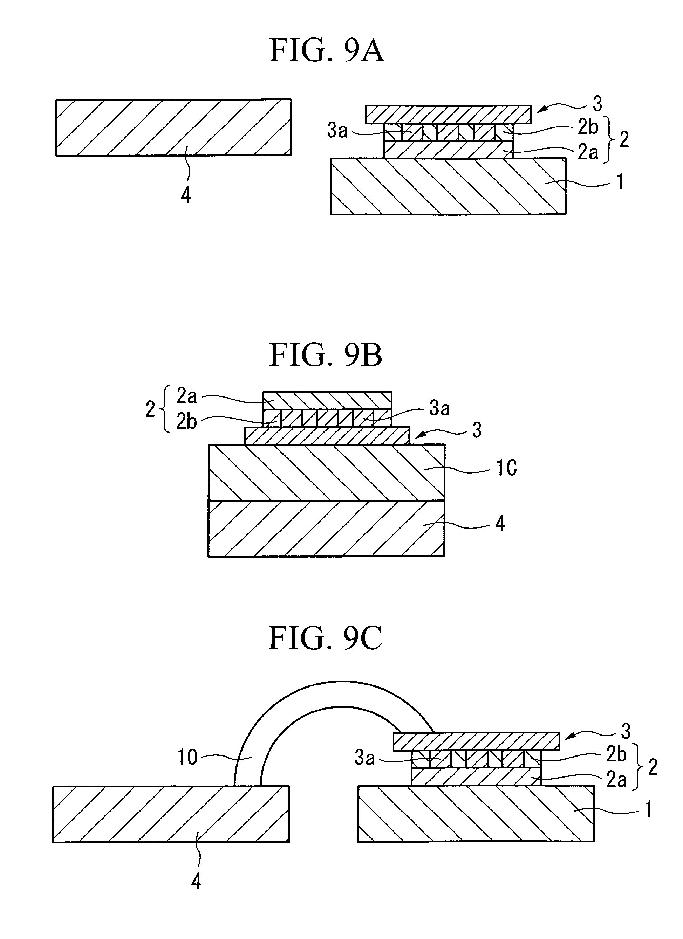

Moreover, the positioning of the ultraviolet light source 4 (the irradiation position) is not limited to a position above the work 2 and the mold 3 mounted on the stage 1 as illustrated in FIG. 2, and this position may be altered as appropriate. For example, as illustrated in FIG. 9A, the ultraviolet light source 4 may be positioned to one side above the stage 1, so that the work 2 and the mold 3 positioned on top of the stage 1 are irradiated with ultraviolet light from the side. Alternatively, as illustrated in FIG. 9B, the ultraviolet light source 4 may be positioned beneath a stage 1C formed of a material that transmits ultraviolet light, so that the work 2 and the mold 3 positioned on top of this stage 1C can be irradiated with ultraviolet light from beneath the stage 1C. Moreover, as illustrated in FIG. 9C, the ultraviolet light source 4 may be positioned in a location distant from the stage 1, and a light guide 10 provided that is capable of transmitting the ultraviolet light irradiated from the ultraviolet light source 4, thereby enabling the ultraviolet light to be irradiated via the light guide 10 and onto the work 2 and the mold 3 positioned on top of the stage 1.

### (Modified example of method for bringing the work 2 and the mold 3 into close contact)

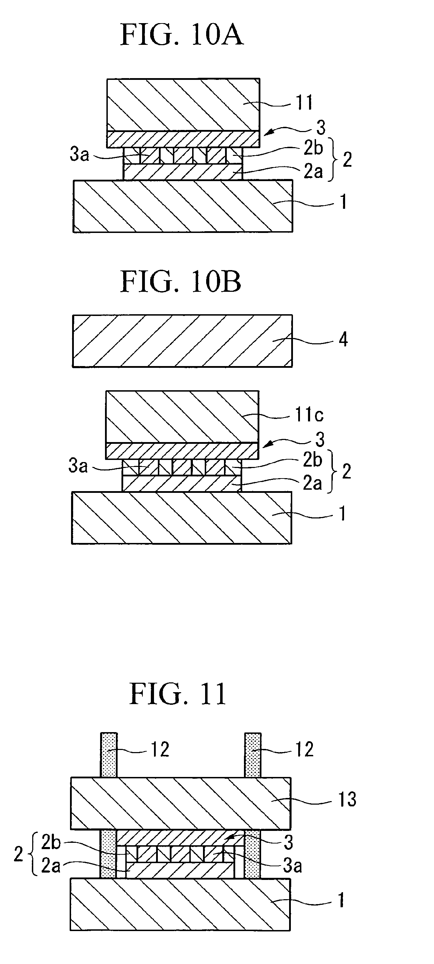

In the present embodiment, there are no particular limitations on the method used for applying pressure to the mold 3 to bring the mold 3 into close contact with the work 2. For example, as illustrated in FIG. 1 and FIG. 2, compressed air or the like may be blown onto the top of the mold 3 to bring the work 2 and the mold 3 into close contact. Alternatively, as illustrated in FIG. 10A, following positioning of the mold 3 on the work 2 mounted on the stage 1, a weight 11 may be placed on the mold 3 to achieve the close contact between the work 2 and the mold 3, or as illustrated in FIG. 10B, irradiation of the ultraviolet light from the ultraviolet light source 4 may be conducted with a weight 11c formed from a material that transmits ultraviolet light still positioned on top of the mold 3. Moreover, as illustrated in FIG. 11, guide rails 12 may be provided on the stage 1, and a press machine having a press plate 13 that moves up and down along these guide rails 12 may then be used to bring the mold 3 into close contact with the work 2.

### (Other temperature rise suppression means)

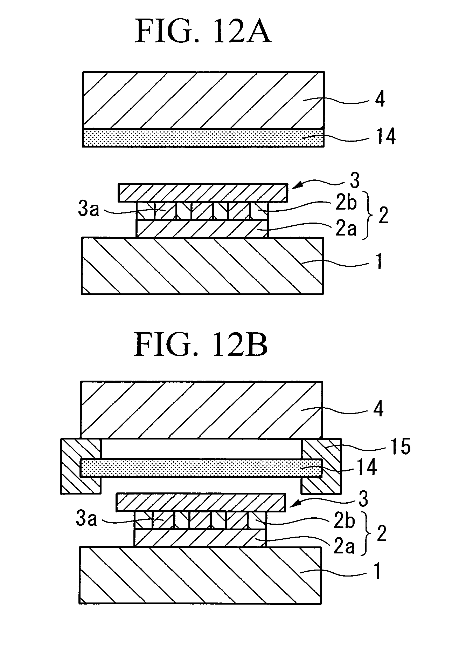

When performing the UV nanoimprint method of the present embodiment, in order to better prevent rise in the temperature of the work 2 and the mold 3, a heat ray cut filter may be used in the ultraviolet light source 4, or the work 2 and the mold 3 may be cooled. In those cases where a heat ray cut filter is used with the ultraviolet light source 4, there are no particular limitations on the variety of heat ray cut filter used, provided it is capable of transmitting ultraviolet light. Further, examples of the method used for attaching the heat ray cut filter to the ultraviolet light source 4 include a method illustrated in FIG. 12A, where a heat ray cut filter 14 is bonded directly to the irradiation window of the ultraviolet light source 4, and a method illustrated in FIG. 12B, where a holder 15 is provided between the mold 3 and the ultraviolet light source 4, and the heat ray cut filter 14 is then set within this holder 15.

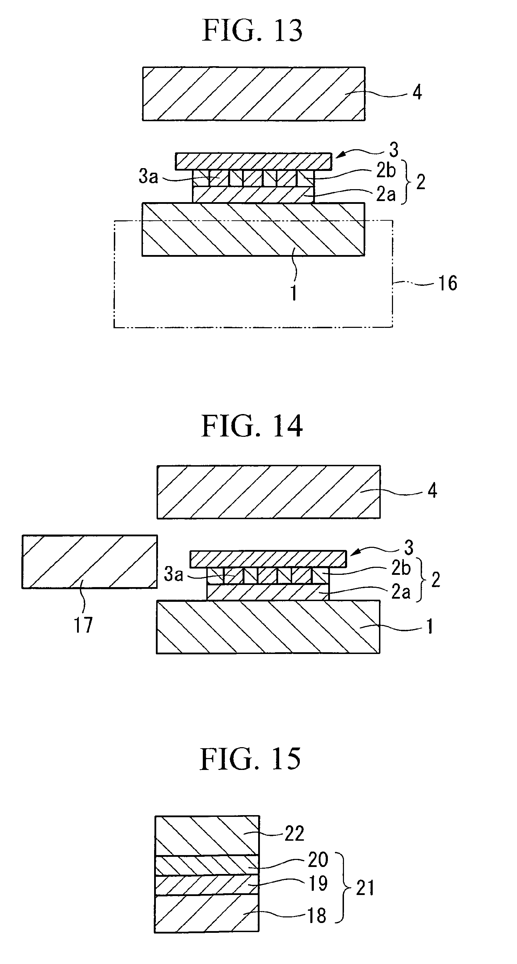

Furthermore, in the present embodiment, there are no particular limitations on the method used for cooling the work 2 and the mold 3, and for example, as illustrated in FIG. 4, a flow passage 7 for cooling water or a coolant gas may be provided within the stage 1 to cool the stage 1, resulting in cooling of the work 2 and the mold 3. Alternatively, as illustrated in FIG. 13, a cooling method may be employed in which a water tank 16 containing cold water is provided, and this water tank is used to cool the stage 1, thereby cooling the work 2 and the mold 3. Moreover, as illustrated in FIG. 14, another cooling method may be used in which a coolant gas outlet 17 is provided between the stage 1 and the ultraviolet light source 4, and a coolant gas is then blown onto the work 2 and the mold 3 from this outlet 17.

### (Pattern formation conditions)

In the present embodiment, the pressure employed when pressing the mold 3 against the work 2 varies depending on factors such as the material and shape of the mold 3, the material and shape of the substrate on the side of the work 2, and the variety of ultraviolet-curable resin film being used, but the pressure is preferably greater than 0 Pa but not more than 50 MPa. If absolutely no pressure is applied, then the surface of the work 2 and the mold 3 may not adopt a totally parallel arrangement, meaning portions may occur where the thin film of the ultraviolet-curable resin and the mold 3 do not make contact, or the pattern surface may not adopt a totally parallel arrangement relative to the substrate surface of the work 2, meaning the pattern may be transferred at an angle. In contrast, if the applied pressure is too great, then the mold 3 may deform, and the precision of the pattern transfer may deteriorate.

In this embodiment, the intensity of the ultraviolet light irradiated onto the work 2 is preferably not less than 1 mW/cm² at the surface of the work 2. If the intensity of the ultraviolet light is less than 1 mW/cm², then the intensity becomes overly weak, causing an increase in the curing time for the thin film of the ultraviolet-curable resin and a reduction in the productivity and therefore it is not preferable. Further, in the present embodiment, irradiation of the ultraviolet light onto the work 2 is preferably started after an interval of at least 0.2 seconds has passed from the point where pressing of the mold 3 against the work 2 is started.
If this interval from the point where pressing of the mold 3 against the work 2 is started is too short, then curing may occur before the ultraviolet-curable resin of the work 2 has satisfactorily penetrated into the pattern of the mold 3, resulting in a poor transfer of the pattern and therefore it is not preferable. Moreover, in the present embodiment, in order to achieve satisfactory curing of the ultraviolet-curable resin and allow the UV nanoimprint method to be performed with favorable efficiency, the irradiation time of the ultraviolet light onto the work 2 is preferably not less than 0.1 seconds and not more than 10 minutes.

In the present embodiment, although there are no particular limitations on the atmosphere in which the ultraviolet light irradiation is performed, in those cases where the ultraviolet-curable resin applied to the work 2 is a radical curable resin, the irradiation is preferably performed in an atmosphere of an inert gas such as nitrogen, whereas in those cases where the ultraviolet-curable resin is a cationic curable resin, the irradiation is preferably performed in a dry air atmosphere or the like. The curing rate can be increased by this type of appropriate adjustment of the atmosphere under which the ultraviolet light irradiation is performed. Further, by performing the ultraviolet light irradiation under vacuum conditions, voids within the ultraviolet-curable resin can be reduced, and the curing rate can be increased.

### <Method for producing magnetic recording medium>

Next is a description of a method for producing a magnetic recording medium using the UV nanoimprint method described above. FIG. 15 to FIG. 17 are process cross-sectional views illustrating a method for producing a magnetic recording medium that represents one embodiment of the present invention. The method for producing a magnetic recording medium according to this embodiment basically includes forming a thin film composed of an ultraviolet-curable resin on a magnetic recording medium having a magnetic layer formed on the surface of a substrate, forming a pattern on the thin film using the UV nanoimprint method described above, and processing the magnetic layer using the pattern. In those cases where processing of a magnetic recording medium is performed using the above UV nanoimprint method, there are no particular limitations on the magnetic recording medium used, and for example, a medium prepared by forming a magnetic layer and a protective layer and the like on the surface of a non-magnetic substrate may be used.
The magnetic layer formed on the surface of the non-magnetic substrate may be either an in-plane magnetic recording layer or a perpendicular magnetic recording layer. One example of the procedure for processing a magnetic recording medium using the UV nanoimprint method according to the present embodiment is described below.

In the method for producing a magnetic recording medium, first, as illustrated in FIG. 15, a magnetic recording medium 21 composed of a non-magnetic substrate 18, a magnetic layer 19 formed on the surface of the non-magnetic substrate 18, and a protective layer 20 provided on top of the magnetic layer 19 is coated with an ultraviolet-curable resin to form a thin film 22 of the ultraviolet-curable resin.

There are no particular limitations on the ultraviolet-curable resin that constitutes the thin film 22, provided it is able to undergo curing in the presence of a photopolymerization initiator, and specific examples include the resins listed above that are able to be used in the production of the resin replica mold, as well as resins containing a (meth)acryloyl group such as adamantyl (meth)acrylate and derivatives thereof, tricyclodecanedimethanol di(meth)acrylate, tris((meth)acryloyloxyethyl) isocyanurate and (meth)acryloyl group-containing silsesquioxanes, and resins containing an oxetanyl group such as oxetanyl group-containing silsesquioxanes. These resins may be used individually or in combinations thereof, and other additives such as photopolymerization initiators, sensitizers, surface modifiers, viscosity modifiers and solvents and the like may also be added freely as required.
Although not essential, it is preferable to select different resins for the ultraviolet-curable resin used for producing the resin replica mold and the ultraviolet-curable resin that constitutes the thin film 22. If the same resin is used for both members, then it is preferable to increase the conversion rate of the curing reaction during production of the resin replica mold.
Furthermore, there are no particular limitations on the method used for applying the ultraviolet-curable resin to the magnetic recording medium 21 to form the thin film 22, and typical methods such as spin coating, dip coating, spray coating and inkjet printing may be used.

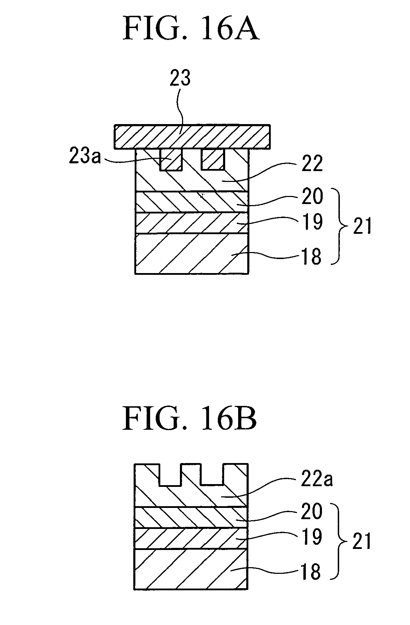

Next, as illustrated in FIG. 16A, a mold 23 is pressed down into close contact with the thin film 22 formed on the magnetic recording medium 21, and then as illustrated in FIG. 16B, the UV nanoimprint method described above is used to transfer the pattern 23a formed on the mold 23 to the thin film 22, thereby forming a patterned thin film layer 22a. In this embodiment, the mold 23 is preferably a resin replica mold described above. By using such a resin replica mold, the contact between the magnetic recording medium 21 and the mold improves, thereby ensuring a high level of processing precision can be achieved, the mold replacement costs are significantly reduced should the mold become damaged, the productivity can be improved, and therefore it is preferable.

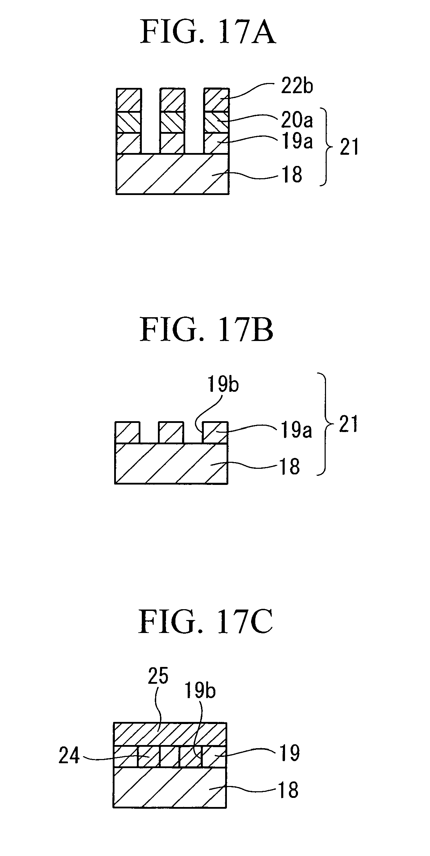

Subsequently, as illustrated in FIG. 17A, a thin film pattern 22b formed by dry etching of the patterned thin film layer 22a is used as a mask to remove portions of the protective layer 20 and the magnetic layer 19 by a typical method such as dry etching or the like. Next, as illustrated in FIG. 17B, a typical method such as ashing is used to peel off the patterned thin film 22b and the protective layer 20a, and then, as illustrated in FIG. 17C, the concave portions 19b within the patterned magnetic layer 19a are filled with a non-magnetic material 24, and once the entire top surface is smooth, a new protective layer 25 is laminated on top of the structure. This completes the production of the magnetic recording medium.

The above description represents one example of the procedure for using the UV nanoimprint method of the present invention to process and produce a magnetic recording medium, but the present embodiment is not limited to the procedure outlined above.
For example, a procedure may be used in which a mask layer of a metal or the like is formed on the magnetic recording medium 21, an ultraviolet-curable resin is applied to this mask layer to form a thin film, the resulting thin film formed from the ultraviolet-curable resin layer is patterned using the UV nanoimprint method of the present invention, the patterned thin film layer composed of the ultraviolet-curable resin is then used to pattern the mask layer, and the patterned mask layer is subsequently used to pattern the underlying magnetic layer. Further, instead of removing portions of the magnetic layer to separate adjacent track regions, ion or reactive gas irradiation may be used to generate non-magnetic regions that separate the track regions.

### EXAMPLES

The present invention is described in further detail below based on a series of examples, but the present invention is in no way limited by these examples.

### <Example 1: Temperature rise caused by ultraviolet light irradiation>

In example 1, in order to confirm the temperature rise effect caused by ultraviolet light irradiation, the comparative evaluation described below was performed. First, a polyethylene terephthalate film (product name: COSMOSHINE A4100, manufactured by Toyobo Co., Ltd., thickness: 100 µm) was cut to form circular test pieces having a diameter of 2 cm. Subsequently, in a room set to a room temperature of 25°C, the surface of each test piece was irradiated with ultraviolet light from one of the two light sources described below, and the surface temperature of the test piece was then measured. The results are listed below in Table 1.

### (Example 1) Light source: light emitting diode-based spot light source, wavelength: 365 nm, intensity: 40 mW/cm², irradiation time: 12.5 seconds

### (Comparative example 1) Light source: continuously lit lamp-based spot light source, intensity: 40 mW/cm², irradiation time: 12.5 seconds

**[Table 1]**

| | Ultraviolet light source | Temperature (°C) |
|---|---|---|
| Example 1 | Light emitting diode-based spot light source (ANUJ61520C, manufactured by Matsushita Electric Works Co., Ltd.) | 32 |
| Comparative example 1 | Continuously lit lamp-based spot light source (ANUP5252L, manufactured by Matsushita Electric Works Co., Ltd.) | 63 |

As is evident from Table 1, in the comparative example 1 that used the continuously lit lamp-based spot light source as a light source, the temperature of the surface of the test piece rose to 63°C. In contrast, in the example 1 that used the light emitting diode-based spot light source as a light source, the temperature of the surface of the test piece was 32°C, confirming that rise in the temperature of the test piece was able to be effectively suppressed.

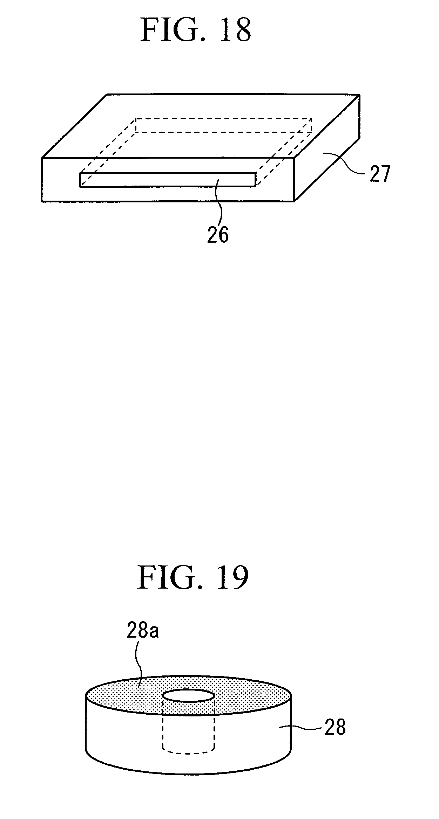

Next, using the same conditions as example 1, the polyethylene terephthalate film was mounted on top of a stainless steel plate 27 of width 10 cm, breadth 10 cm and thickness 2 cm which, as illustrated in FIG. 18, had a rectangular flow passage 26 of width 8 cm, breadth 10 cm and height 1 cm provided therein, and the above test was then performed while cooling water of 20°C was passed through the flow passage at a rate of 40 mL/second. The result of this test revealed a temperature at the surface of the test piece following the ultraviolet light irradiation of 26°C. Further, using the same conditions as example 1, another test was performed with a heat ray cut filter (product name: HAF-50S-30H, manufactured by Sigma Koki Co., Ltd., heat ray cut wavelength: 800 to 2,000 nm) attached to the head of the light source. The result of this test revealed a temperature at the surface of the test piece following the ultraviolet light irradiation of 30°C. These results confirmed that by also employing other devices such as stage cooling and a heat ray cut filter, rise in the temperature of the surface of the test piece could be even more effectively suppressed.

### <Example 2: Production of magnetic recording medium>

In example 2, the UV nanoimprint method according to the first embodiment of the present invention was used to produce a resin replica mold, and the mold was then used to produce a magnetic recording medium.

### (Preparation of resin replica mold)

First, a polyethylene terephthalate film (product name: COSMOSHINE A4100, manufactured by Toyobo Co., Ltd., thickness: 100 µm) was cut to form a circular donut-shaped sample having a diameter of 55 mm and a hole diameter of 12 mm. Subsequently, as illustrated in FIG. 19, a liquid resin for UV imprinting (product name: NIF-A-1, manufactured by Asahi Glass Co., Ltd.) was applied to a coating surface 28a with a bar coater, in an amount sufficient to form a coating with a thickness of approximately 10 µm, thus completing preparation of a work 28.

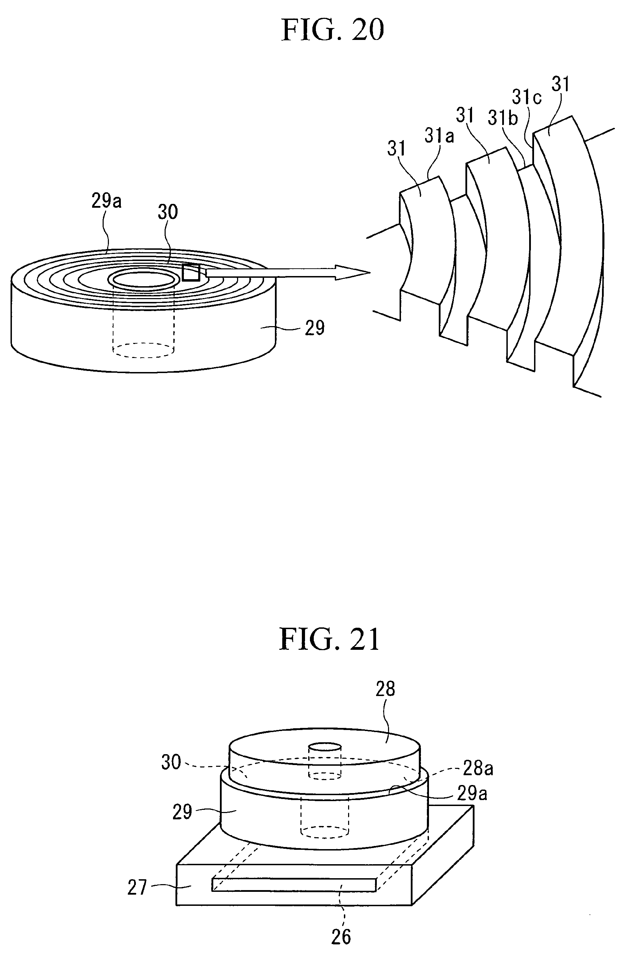

As illustrated in FIG. 20, a mother stamper 29 used in the production of the resin replica mold is a Ni circular plate shape having a diameter of 65 mm, a hole diameter of 12 mm and a thickness of 0.3 mm. A pattern region 30 is formed on the surface 29a of this mother stamper 29 in a donut-shaped region having an outer diameter of 44 mm and an inner diameter of 18 mm. Further, as illustrated in FIG. 20, a concentric circular pattern 31 in which the width 31a of each convex portion is 120 nm, the width 31 b of each concave portion is 80 nm, and the height 31c of the concave-convex pattern is 80 nm is formed within the pattern region 30.

Next, as illustrated in FIG. 21, the mother stamper 29 was mounted on a stainless steel sheet 27 (see FIG. 18) with the pattern region 30 facing upward, and the previously prepared work 28 was mounted on top of the pattern region 30 with the coating surface 28a facing downward. Subsequently, a pressure was applied to the work 28 to bring it into close contact with the mother stamper 29, and after holding this state for 15 seconds, cooling water at 20°C was passed through the flow passage 26 of the stainless steel sheet 27 at a flow rate of 40 mL/second while ultraviolet light with an intensity of 40 mW/cm² was irradiated onto the work 28 for 12.5 seconds using a light emitting diode-based spot light source (Aicure ANUJ61520C, manufactured by Matsushita Electric Works Co., Ltd.) that had a heat ray cut filter (product name: HAF-50S-30H, manufactured by Sigma Koki Co., Ltd.) attached to the head. Following this irradiation, the mold was released, completing the production of a resin replica mold onto which the pattern 31 of the mother stamper 29 had been transferred.

### (Preparation of ultraviolet-curable resin solution for application to magnetic recording medium)

Next, an ultraviolet-curable resin for application to the magnetic recording medium was prepared. 6.5 g of an oxetanyl group-containing silsesquioxane resin (product name: OX-SQ-H, manufactured by Toagosei Co., Ltd.) was combined with 0.20 g of a photocationic polymerization initiator (product name: CPI-100P, manufactured by San-Apro Ltd.), 0.10 g of 9,10-dibutoxyanthracene as a sensitizer, and 93.2 g of propylene glycol monomethyl ether acetate as a solvent, and the resulting mixture was dispersed for 12 hours at 60 rpm using a mixing rotor in a dark room, thus completing preparation of an ultraviolet-curable resin solution A.

### (UV nanoimprinting on magnetic recording medium)

Pattern formation was conducted on a magnetic recording medium using a UV nanoimprint method. First, a donut-shaped glass substrate having a diameter of 48 mm, a hole diameter of 12 mm and a thickness of 0.6 mm was prepared. A magnetic recording medium was formed by depositing a perpendicular recording-type magnetic layer and a protective layer on the donut-shaped glass substrate, and the previously prepared ultraviolet-curable resin solution A was then applied by spin coating to form a coating with a thickness of approximately 60 nm. Subsequently, the magnetic recording medium with the applied coating of the ultraviolet-curable resin solution A was mounted on the stainless steel sheet 27 illustrated in FIG. 18 with the coated surface facing upward. The previously prepared resin replica mold was then placed on top of the coated surface of the magnetic recording medium with the pattern surface of the mold facing downward. Next, a quartz glass plate of width 10 cm, breadth 10 cm and thickness 5 mm was placed on top of the resin replica mold, and after allowing the structure to stand for 5 seconds, the quartz glass plate was removed and the structure was left to stand for a further 10 seconds. Subsequently, cooling water at 20°C was passed through the flow passage 26 of the stainless steel sheet 27 at a flow rate of 40 mL/second while ultraviolet light with an intensity of 40 mW/cm² was irradiated for 25 seconds using a light emitting diode-based spot light source (Aicure ANUJ61520C, manufactured by Matsushita Electric Works Co., Ltd.) that had a heat ray cut filter (product name: HAF-50S-30H, manufactured by Sigma Koki Co., Ltd.) attached to the head. Following this irradiation, the mold was released, completing the production of a magnetic recording medium.

Three random locations on the patterned film-supporting magnetic recording medium produced in the manner described above were inspected using an atomic force microscope, and the shape of the concave-convex pattern was measured. The results are listed in Table 2.

**[Table 2]**

| | Convex portion width | Concave portion width | Concave-convex pattern |
|---|---|---|---|
| | (nm) | (nm) | height (nm) |
| Inspection location 1 | 119 | 80 | 78 |
| Inspection location 2 | 119 | 81 | 80 |
| Inspection location 3 | 121 | 79 | 79 |

As is evident from the results in Table 2, the pattern formed in the magnetic recording medium was able to formed with substantially the same dimensions as the pattern 31 formed on the surface of the mother stamper 29, which had a width 31a of the convex portions of 120 nm, a width 31b of the concave portions of 80 nm, and a height 31c of the concave-convex pattern of 80 nm. These results confirmed that by employing the UV nanoimprint method of the present invention, the pattern of a mother stamper was able to formed on a resin replica mold with favorable precision, and the resulting resin replica mold was then able to be used to form a pattern on a magnetic recording medium with favorable precision.

### <Example 3: Temperature rise caused by ultraviolet light irradiation>

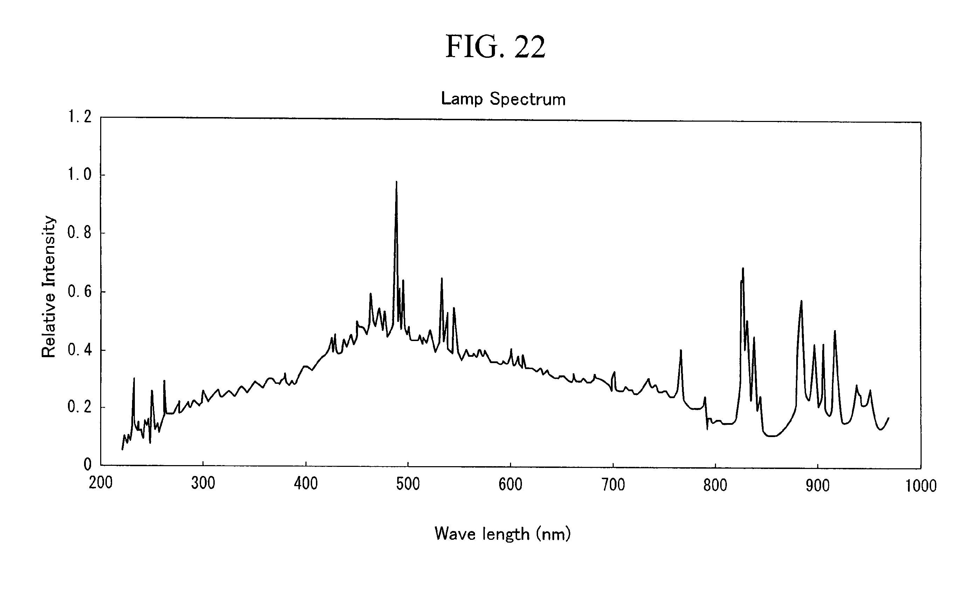

In example 3, in order to confirm the temperature rise effect caused by ultraviolet light irradiation, the comparative evaluation described below was performed. First, a polyethylene terephthalate film (product name: COSMOSHINE A4100, manufactured by Toyobo Co., Ltd., thickness: 100 µm) was cut to form circular test pieces having a diameter of 2 cm. Subsequently, in a room set to a room temperature of 25°C, the surface of each test piece was irradiated with ultraviolet light from one of the two light sources described below, and the surface temperature of the test piece was then measured. The results are listed below in Table 3.
(Example 3) Light source: continuous pulsed emission-type quartz xenon lamp (Aicure ANUP-8, manufactured by Matsushita Electric Works Co., Ltd.), intensity: 40 mW/cm², irradiation conditions: 0.1 ms per pulse, 10 Hz, irradiation for 12.5 seconds. The light emission spectrum is shown in FIG. 22.

### (Comparative example 2) Light source: continuously lit lamp-based spot light source, intensity: 40 mW/cm², irradiation time: 12.5 seconds

**[Table 3]**

| | Ultraviolet light source | Temperature (°C) |
|---|---|---|
| Example 3 | Continuous pulsed emission-type quartz xenon lamp (ANUP-8, manufactured by Matsushita Electric Works Co., Ltd.) | 28 |
| Comparative example 2 | Continuously lit lamp-based spot light source (ANUP5252L, manufactured by Matsushita Electric Works Co., Ltd.) | 63 |

As is evident from Table 3, in the comparative example 2 that used the continuously lit lamp-based spot light source as a light source, the temperature of the surface of the test piece rose to 63°C. In contrast, in the example 3 that used the continuous pulsed emission-type light source, the temperature of the surface of the test piece was 28°C, confirming that rise in the temperature of the test piece was able to be effectively suppressed.

Next, using the same conditions as example 3, the polyethylene terephthalate film was mounted on top of a stainless steel plate 27 of width 10 cm, breadth 10 cm and thickness 2 cm which, as illustrated in FIG. 18, had a rectangular flow passage 26 of width 8 cm, breadth 10 cm and height 1 cm provided therein, and the above test was then performed while cooling water of 20°C was passed through the flow passage at a rate of 40 mL/second. The result of this test revealed a temperature at the surface of the test piece following the ultraviolet light irradiation of 25°C. Further, using the same conditions as example 3, another test was performed with a heat ray cut filter (product name: HAF-50S-30H, manufactured by Sigma Koki Co., Ltd., heat ray cut wavelength: 800 to 2,000 nm) attached to the head of the light source. The result of this test revealed a temperature at the surface of the test piece following the ultraviolet light irradiation of 26°C. These results confirmed that by also employing other devices such as stage cooling and a heat ray cut filter, rise in the temperature of the surface of the test piece could be even more effectively suppressed.

### <Example 4: Production of magnetic recording medium>

In example 4, the UV nanoimprint method according to the second embodiment of the present invention was used to produce a resin replica mold, and the mold was then used to produce a magnetic recording medium.

### (Preparation of resin replica mold)

First, a polyethylene terephthalate film (product name: COSMOSHINE A4100, manufactured by Toyobo Co., Ltd., thickness: 100 µm) was cut to form a circular donut-shaped sample having a diameter of 55 mm and a hole diameter of 12 mm. Subsequently, as illustrated in FIG. 19, a liquid resin for UV imprinting (product name: NIF-A-1, manufactured by Asahi Glass Co., Ltd.) was applied to the coating surface 28a with a bar coater, in an amount sufficient to form a coating with a thickness of approximately 10 µm, thus completing preparation of a work 28.

As illustrated in FIG. 20, a mother stamper 29 used in the production of the resin replica mold is a Ni circular plate shape having a diameter of 65 mm, a hole diameter of 12 mm and a thickness of 0.3 mm. A pattern region 30 is formed on the surface 29a of this mother stamper 29 in a donut-shaped region having an outer diameter of 44 mm and an inner diameter of 18 mm. Further, as illustrated in FIG. 20, a concentric circular pattern 31 in which the width 31a of each convex portion is 120 nm, the width 31b of each concave portion is 80 nm, and the height 31c of the concave-convex pattern is 80 nm is formed within the pattern region 30.

Next, as illustrated in FIG. 21, the mother stamper 29 was mounted on a stainless steel sheet 27 (see FIG. 18) with the pattern region 30 facing upward, and the previously prepared work 28 was mounted on top of the pattern region 30 with the coating surface 28a facing downward. Subsequently, a pressure was applied to the work 28 to bring it into close contact with the mother stamper 29, and after holding this state for 15 seconds, cooling water at 20°C was passed through the flow passage 26 of the stainless steel sheet 27 at a flow rate of 40 mL/second while ultraviolet light with an intensity of 40 mW/cm² was irradiated onto the work 28 using a continuous pulsed emission-type quartz xenon lamp (Aicure ANUP-8, manufactured by Matsushita Electric Works Co., Ltd.) that had a heat ray cut filter (product name: HAF-50S-30H, manufactured by Sigma Koki Co., Ltd.) attached to the head, with the irradiation performed under conditions including 0.1 ms per pulse, 10 Hz, and an irradiation time of 12.5 seconds. Following this irradiation, the mold was released, completing the production of a resin replica mold onto which the pattern 31 of the mother stamper 29 had been transferred.

### (Preparation of ultraviolet-curable resin solution for application to magnetic recording medium)

Next, an ultraviolet-curable resin for application to the magnetic recording medium was prepared. 6.5 g of an oxetanyl group-containing silsesquioxane resin (product name: OX-SQ-H, manufactured by Toagosei Co., Ltd.) was combined with 0.20 g of a photocationic polymerization initiator (product name: CPI-100P, manufactured by San-Apro Ltd.), 0.10 g of 9,10-dibutoxyanthracene as a sensitizer, and 93.2 g of propylene glycol monomethyl ether acetate as a solvent, and the resulting mixture was dispersed for 12 hours at 60 rpm using a mixing rotor in a dark room, thus completing preparation of an ultraviolet-curable resin solution A.

### (UV nanoimprinting on magnetic recording medium)

Finally, pattern formation was conducted on a magnetic recording medium using a UV nanoimprint method. First, a donut-shaped glass substrate having a diameter of 48 mm, a hole diameter of 12 mm and a thickness of 0.6 mm was prepared. A magnetic recording medium was formed on the donut-shaped glass substrate by depositing a perpendicular recording-type magnetic layer and a protective layer, and the previously prepared ultraviolet-curable resin solution A was then applied by spin coating in an amount sufficient to form a coating with a thickness of approximately 60 nm. Subsequently, the magnetic recording medium with the applied coating of the ultraviolet-curable resin solution A was mounted on the stainless steel sheet 27 illustrated in FIG. 18 with the coated surface facing upward. The previously prepared resin replica mold was then placed on top of the coated surface of the magnetic recording medium with the pattern surface of the mold facing downward. Next, a quartz glass plate of width 10 cm, breadth 10 cm and thickness 5 mm was placed on top of the resin replica mold, and after allowing the structure to stand for 5 seconds, the quartz glass plate was removed and the structure was left to stand for a further 10 seconds. Subsequently, cooling water at 20°C was passed through the flow passage 26 of the stainless steel sheet 27 at a flow rate of 40 mL/second while ultraviolet light with an intensity of 40 mW/cm² was irradiated using a continuous pulsed emission-type quartz xenon lamp (Aicure ANUP-8, manufactured by Matsushita Electric Works Co., Ltd.) that had a heat ray cut filter (product name: HAF-50S-30H, manufactured by Sigma Koki Co., Ltd.) attached to the head, with the irradiation performed under conditions including 0.1 ms per pulse, 10 Hz, and an irradiation time of 25 seconds. Following this irradiation, the mold was released, completing the production of a magnetic recording medium.

Three random locations on the patterned film-supporting magnetic recording medium produced in the manner described above were inspected using an atomic force microscope, and the shape of the concave-convex pattern was measured. The results are listed in Table 4.

**[Table 4]**

| | Convex portion width | Concave portion width | Concave-convex pattern |
|---|---|---|---|
| | (nm) | (nm) | height (nm) |
| Inspection location 1 | 119 | 80 | 78 |
| Inspection location 2 | 119 | 81 | 80 |
| Inspection location 3 | 121 | 79 | 79 |

As is evident from the results in Table 4, the pattern formed in the magnetic recording medium was able to formed with substantially the same dimensions as the pattern 31 formed on the surface of the mother stamper 29, which had a width 31a of the convex portions of 120 nm, a width 31b of the concave portions of 80 nm, and a height 31c of the concave-convex pattern of 80 nm. These results confirmed that by employing the UV nanoimprint method of the present invention, the pattern of a mother stamper was able to formed on a resin replica mold with favorable precision, and the resulting resin replica mold was then able to be used to form a pattern on a magnetic recording medium with favorable precision.

## Claims

1. A UV nanoimprint method comprising: performing compression molding by pressing a mold having a pattern formed on the surface thereof against a work prepared by forming a thin film composed of an ultraviolet-curable resin on a substrate, and irradiating with ultraviolet light, either concurrently with said compression molding or after said compression molding, thereby transferring said pattern to said thin film, wherein
said ultraviolet light is irradiated using an ultraviolet light irradiation apparatus equipped with temperature rise suppression means that suppresses rise in a temperature of said work and said mold, and a light source that does not continuously emit heat rays together with ultraviolet light is used as a light source of said ultraviolet light irradiation apparatus.

2. The UV nanoimprint method according to claim 1, wherein said temperature rise suppression means comprises using a light emitting diode-based light source as a light source of said ultraviolet light irradiation apparatus.

3. The UV nanoimprint method according to claim 1, wherein said temperature rise suppression means comprises using a continuous pulsed emission-type light source as a light source of said ultraviolet light irradiation apparatus.

4. The UV nanoimprint method according to claim 2, wherein said light emitting diode-based light source emits ultraviolet light with a wavelength of 360 to 370 nm.

5. The UV nanoimprint method according to claim 3, wherein said continuous pulsed emission-type light source is a quartz xenon lamp.

6. The UV nanoimprint method according to claim 1, wherein said ultraviolet light is irradiated with a heat ray cut filter provided between said light source and said work.

7. The UV nanoimprint method according to claim 1, wherein said ultraviolet light irradiation apparatus comprises a stage on which said work is mounted, and said stage is subjected to cooling while said ultraviolet light is irradiated.

8. A method for producing a resin replica mold, said method comprising: using a thin film composed of an ultraviolet-curable resin formed on top of a resin film, and using the UV nanoimprint method according to claim 1 to transfer a mother stamper pattern to said thin film.

9. The method for producing a resin replica mold according to claim 8, wherein said ultraviolet-curable resin is a solventless liquid.

10. A resin replica mold produced using the method according to claim 8.

11. A method for producing a magnetic recording medium, said method comprising: forming a thin film composed of an ultraviolet-curable resin on a magnetic recording medium comprising a magnetic layer formed on the surface of a substrate, forming a pattern on said thin film using the UV nanoimprint method according to claim 1, and processing said magnetic layer using said pattern.

12. The method for producing a magnetic recording medium according to claim 11, wherein the resin replica mold according to claim 10 is used as said mold.

13. A magnetic recording medium produced using the method for producing a magnetic recording medium according to claim 11.

14. A magnetic recording/reproducing apparatus equipped with the magnetic recording medium according to claim 13.
